## Europäisches Patentamt

## European Patent Office

## Office européen des brevets

(11) Numéro de publication: **0 270 821**

**A1**

# (12) DEMANDE DE BREVET EUROPEEN

(21) Numéro de dépôt: **87115969.5**

(22) Date de dépôt: **30.10.87**

(51) Int. Cl.4: **G01R 1/20**

(30) Priorité: **10.11.86 CA 522608**

(43) Date de publication de la demande:
**15.06.88 Bulletin 88/24**

(84) Etats contractants désignés:
**CH DE FR LI SE**

(71) Demandeur: **HYDRO-QUEBEC**
**75, Boulevard Dorchester Ouest**
**Montréal Québec H2Z 1A4(CA)**

(72) Inventeur: **Leclerc, Marc**
**91 rue Marie Boulard**
**Boucherville Québec J4B 4B8(CA)**
Inventeur: **Malewski, Ryszard**
**190 Putney**
**St. Lambert Québec J4P 3B1(CA)**
Inventeur: **Thivierge, Jean-Paul**
**3055 Duvivier**
**Longueil Québec J4L 3W9(CA)**

(74) Mandataire: **Casalonga, Axel et al**
**BUREAU D.A. CASALONGA - JOSSE**
**Morassistrasse 8**
**D-8000 Munich 5(DE)**

(54) **Système de compensation de la réponse d'un shunt de mesure.**

(57) Afin de réduire l'écart entre la réponse d'un shunt substantiellement rectangulaire et l'onde appliquée à celui-ci, écart dû à des effets pelliculaire et de proximité, la présente invention propose un shunt comprenant un système de compensation desdits effets, lequel est caractérisé par un parcours optimisé du circuit de mesure de la différence de potentiel produite dans le shunt lors du passage d'un courant. Ledit parcours part du centre du matériau résistif dont est constitué le shunt et progresse vers la paroi externe dudit matériau résistif selon une fonction qui n'est pas monotone et qui peut même présenter des boucles. Plus particulièrement, on propose un tel shunt ayant une géométrie rectangulaire permettant le maximum de dissipation de la quantité de chaleur produite par ledit shunt dans le milieu ambient.

FIG. 1

# SYSTEME DE COMPENSATION DE LA REPONSE D'UN SHUNT DE MESURE

La présente invention se rapporte à un système de compensation des effets pelliculaire et de proximité pour la réponse d'un shunt substantiellement rectangulaire de mesure.

Le shunt fonctionne sur le principe que le passage d'un courant produit une différence de potentiel dans la résistance du chunt et que cette différence de potentiel permet par la loi d'Ohm de calculer l'intensité du courant. Le circuit de mesure de cette différence de potentiel est constitué d'un fil isolé qui est inséré dans une rainure coupée dans le matériau résistif du shunt monolithique. Deux facteurs peuvent limiter l'utilisation d'un shunt:

L'erreur causée par une variation de la température du matériau résistif.

L'erreur causée par la réponse à l'échelon de courant qui n'est pas parfaite à cause des effets pelliculaire et de proximité.

Une variation de température du matériau résistif provoque une variation de la valeur nominale du shunt parce que le coefficient thermique de la résistivité n'est pas nul. L'échauffement adiabatique en court-circuit détermine la quantité de matériau résistif alors que l'échauffement en régime permanent détermine la géométrie du shunt. Le shunt dont il est question ici est de gométrie rectangulaire et permet le passage de courants permanents élevés.

La réponse obtenue à la sortie d'un shunt devrait idéalement être une réplique fidèle de l'onde échelon de courant appliquée à son entrée. La réponse d'un shunt réel s'écarte toujours de l'onde échelon à cause premièrement de l'effet pelliculaire dans le matériau résistif et deuxièmement à cause de l'effet de proximité des courants de retour. La réalisation de l'invention consiste en l'optimisation du parcours du circuit de mesure à l'intérieur de l'élément résitif du shunt rectangulaire de façon à réduire l'écart entre la réponse du shunt et l'onde appliquée pour une configuration donnée du shunt et des conducteurs de retour. Le parcours du circuit de mesure de la différence de potentiel entre le centre du shunt rectangulaire et sa paroi externe présente une fonction qui n'est pas monotone.

Dans sa conception la plus large, la présente invention propose un shunt substantiellement rectangulaire de mesure comprenant un système de compensation des effets pelliculaire et de proximité lequel système de compensation est caractérisé par un parcours optimisé du circuit de mesure de la différence de potentiel produite dans le shunt lors du passage d'un courant fort, ledit parcours partant du centre de l'élément résistif et progressant vers la paroi externe dudit élément résistif selon une fonction qui n'est pas monotone et qui peut même présenter des boucles. Plus particulièrement, on propose un tel shunt compensé ayant une géométrie rectangulaire permettant le maximum de dissipation de la quantité de chaleur produite par ledit shunt dans le milieu ambiant.

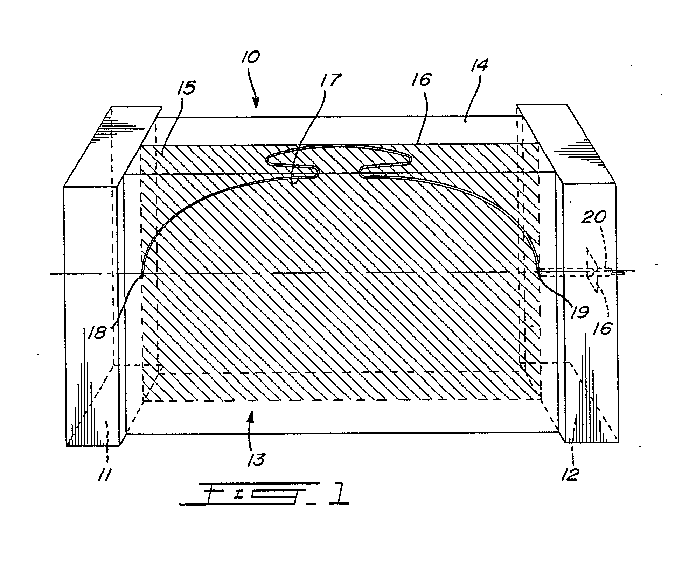

Nous décrirons maintenant une réalisation préférée de la présente invention en se référant à l'exemple illustré à la figure 1 du présent mémoire descriptif représentant un shunt rectangulaire muni d'un système de compensation des effets pelliculaire et de proximité.

Dans ladite figure, le shunt 10 est constitué d'une borne d'entrée du courant fort 11 et d'une borne de sortie du courant fort 12 reliées entre-elles par un élément résistif rectangulaire 13 constitué de deux ou plusieurs barres juxtaposées 14 et 15. Dans le plan de juxtaposition 16 qui de préférence est un plan de symétrie longitudinale passant par l'axe de symétrie longitudinale du shunt, situé à l'interface de contact entre les barres 14 et 15 de l'élément résistif on place un conducteur de mesure 17 dans une rainure taillée selon le profil optimisé désiré. Ce conducteur de mesure a son point de départ 18 situé au centre de l'élément résistif et branché à la borne d'entrée 11 et son point d'arrivée 19 branché à la fiche coaxiale de sortie 20 qui passe au travers de la borne de sortie 12.

Les bornes d'entrée 11 et de sortie 12 peuvent être constituées de barres en laiton ou en cuivre. L'élément résistif 13 peut être constitué d'alliages résistifs tels que le constantan, le manganin ou le nichrome.

Un tel shunt rectangulaire compensé permet de mesurer des courant aussi bien en régime transitoire qu'en régime permanent dans une plage de fréquence s'étandant du continu à plusieurs dizaines de kilohertz. Ces caractéristiques permettent la mesure de courant dans les applications suivantes:
-stations d'essai à fort courant,
-reseaux à courant alternatif et continu,
-systèmes d'alimentation ou la forme d'onde est impulsionnelle.

## Revendications

1. Un shunt de mesure de section rectangulaire substantiellement rectangulaire des effets pelliculaire et de proximité dqans la réponse du shunt, ledit système de compensation étant caractérisé par un parcours optimisé du circuit de mesure de la différence de potentiel produite dans le shunt lors du passage d'un courant fort, ledit parcours partant du centre du matériau résistif dont est constitué le shunt et progressant vers la paroi externe dudit matériau résistif selon une fonction qui n'est pas monotone.

2. Un shunt de mesure tel que revendiqué à la revendication 1, dans lequel le parcours du circuit de mesure de la différence de potentiel présente des boucles dans le matériau résistif.

3. Un shunt de mesure tel que revendiqué à la revendication 2, constitué d'un élément résistif rectangulaire reliant entre-elles une borne d'entrée et une borne de sortie du courant fort appliqué au shunt, ledit élément résistif comprenant une rainure taillée selon le profil optimisé du parcours du circuit de mesure de la différence de potentiel produite dans le shunt et dans laquelle est inséré un conducteur de mesure branché à sonpoint de départ à la borne d'entrée du courant fort et branché à sont pint d'arrivée à une fiche coaxiale de sortie au travers de la borne de sortie du courant fort.

4. Un shunt de mesure tel que revendiqué à la revendication 3, dans lequel l'élément résistif est constitué de deux ou plusieurs barres rectangulaires juxtaposées.

5. Un shunt de mesure tel que revendiqué à la revendication 4, dans lequel la rainure taillée selon le parcours optimisé du circuit de mesure de la différence de potentiel produite dans le shunt est située dans le plan de juxtaposition des deux barres rectangulaires dexl'élément résistif.

6. Un shunt de mesure tel que revendiqué à la revendication 5, dans lequel le plan de juxtaposition des deux barres rectangulaires de l'élément résistif est un plan de symétrie longitudinale.

7. Un shunt de mesure tel que revendiqué à la revendication 6, dans lequel le plan de symétrie longitudinale passe par l'axe de symétrie longitudinale du shunt.

FIG. 1

Office européen des brevets

# RAPPORT DE RECHERCHE EUROPEENNE

Numero de la demande

EP 87 11 5969

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 030 186 (ENERTEC SOCIETE ANONYME) <br> * pages 1-2; figures 1, 4 * <br> --- | 1 | G 01 R 1/20 |
| A | DE-C-3 405 442 (AKTIENGESELLSCHAFT FÜR INDUSTRIELLE ELEKTRONIK) <br> * revendicaton, figures 1, 4 * <br> --- | 1 | |
| A | DE-U-1 837 185 (DEUTSCHE ELEKTRONIK) <br> * en entier * <br> ----- | 1 | |

|  |  |
|---|---|
|  | DOMAINES TECHNIQUES RECHERCHES (Int. Cl.4) |
|  | G 01 R 1/20 |

Le présent rapport a été établi pour toutes les revendications

| Lieu de la recherche | Date d'achèvement de la recherche | Examinateur |
|---|---|---|
| BERLIN | 01-02-1988 | LEMMERICH J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)